Europäisches Patentamt

European Patent Office

Office européen des brevets

(19)

(11) Veröffentlichungsnummer: **0 015 983**
**B1**

(12) **EUROPÄISCHE PATENTSCHRIFT**

(45) Veröffentlichungstag der Patentschrift:
27.10.82

(21) Anmeldenummer: **79900496.5**

(22) Anmeldetag: **18.05.79**

(86) Internationale Anmeldenummer:
**PCT/CH 79/00070**

(87) Internationale Veröffentlichungsnummer:
**WO 80/00640 (03.04.80** Gazette 80/7)

(51) Int. Cl.³: **H 01 L 21/50, H 01 L 23/10,**
**H 01 L 23/04, H 01 L 21/60**

(54) **VERFAHREN ZUR HERSTELLUNG EINES DICHTEN GEHÄUSES FÜR EINEN SCHEIBENFÖRMIGEN, MINDESTENS EINEN PN-ÜBERGANG AUFWEISENDEN HALBLEITERKÖRPER.**

(30) Priorität: **07.09.78 DE 2838997**

(43) Veröffentlichungstag der Anmeldung:
**01.10.80 Patentblatt 80/20**

(45) Bekanntmachung des Hinweises auf die Patenterteilung:
**27.10.82 Patentblatt 82/43**

(84) Benannte Vertragsstaaten:
**CH FR GB**

(56) Entgegenhaltungen:
**US-A-3 443 168**
**H. Mark, N. Gaylord, »Encyclopedia of polymer Science and Technology«, Band 14, 1971, Interscience Publishers, J. Wiley & Sons (New York, London, Sydney, Toronto), Seite 616, »Uses«.**
**P. Kluckow, F. Zeplichal, »Chemie und Technologie der Elastomere«, 1970, Berliner Union (Stuttgart), Seite 379, Abschnitt 10.3.3.3.**

(73) Patentinhaber: **BBC Aktiengesellschaft Brown, Boveri & Cie., CH-5401 Baden (CH)**

(72) Erfinder: **EISELE, Dieter, Edisonstrasse 10, D-6840 Lampertheim (DE)**

Verfahren zur Herstellung eines dichten Gehäuses für einen scheibenförmigen, mindestens einen pn-Übergang aufweisenden Halbleiterkörper

Die Erfindung bezieht sich auf ein Verfahren zur Herstellung eines dichten Gehäuses für einen scheibenförmigen, mindestens einen pn-Übergang aufweisenden Halbleiterkörper, welcher an jeder seiner beiden Hauptoberflächen über Elektrodenteile und einen Druckkontaktkörper als Gehäuseabschluß thermisch und elektrisch druckkontaktierbar ist, wobei jeder Druckkontaktkörper mit einem seinen Rand umlaufenden elastischen Dichtring versehen und in ein hohlzylindrisches, den Rand des Halbleiterkörpers umschließendes — bei Verwendung für steuerbare Leistungs-Halbleiterbauelemente mit einer Durchführung für den Steuerelektrodenanschluß versehenes —, Isoliergehäuse eingesetzt wird.

Das Verfahren findet Anwendung zur Herstellung von Scheibenzellengehäusen für nichtsteuerbare und steuerbare Leistungs-Halbleiterbauelemente, wobei in Sonderfällen auch zwei Halbleiterkörper unter Zwischenlage entsprechender Metallscheiben zwischen die Druckkontaktkörper in das Isoliergehäuse eingesetzt werden können.

Für ein Leistungs-Halbleiterbauelement ist bereits ein Gehäuse mit der vorbeschriebenen Dichtringtechnik vorgeschlagen worden. Bei Durchführung der Dichtringtechnik nach dem älteren Vorschlag müssen die Druckkontaktkörper eine umlaufende Ausnehmung zum Einsetzen des Dichtringes besitzen. Weiterhin ist es zweckmäßig, die Innenseite des Isoliergehäuses aus Keramik zu schleifen, um eine sichere Dichtung zu gewährleisten.

Aufgabe der Erfindung ist es, vorbereitende Arbeiten bei der Herstellung des vorbeschriebenen Gehäuses in Dichtringtechnik einzusparen und dennoch einen dichten Gehäuseabschluß zu erhalten.

Die Lösung dieser Aufgabe besteht darin, daß erfindungsgemäß:

a) durch Elektronenbestrahlung expandierte Schlauchabschnitte als Dichtringe verwendet werden,

b) die Schlauchabschnitte auf die beiden Druckkontaktkörper aufgezogen werden und

c) die Schlauchabschnitte nach ihrem Einsetzen in das Isoliergehäuse zwecks Entspannung erwärmt werden, wobei sie unter Vergrößerung ihrer Wandstärke das Gehäuse abdichten.

Durch Elektronenbestrahlung expandiertes Schlauchmaterial ist an sich bekannt bzw. auf dem Markt erhältlich, z. B. von der Firma Raychem, Großbritannien. Das Material ist ein wärme- und chemikalienbeständiges, vulkanisierbares Fluorelastomer auf der Basis eines Kopolimerisats aus Hexafluorpropylen und Vinylidenfluorid (Römpps Chemie-Lexikon, 7. Auflage, Seite 3844, Stichwort »Viton R«). »Viton« ist ein eingetragenes Warenzeichen. Die Verwendbarkeit solcher Schlauchabschnitte, für Abdichtung von Leitungshalbleiter-Scheibenzellengehäusen ist bisher jedoch nicht erkannt worden.

Vorteilhaft kann jeder Schlauchabschnitt auf den zugehörigen Druckkontaktkörper aufgezogen werden, ohne daß sich im Rand desselben eine Ausnehmung oder Ringnut zur Sicherung einer stabilen Lage des Schlauchabschnittes befinden muß. Nach Einsatz in das Isoliergehäuse genügt eine Erwärmung, um eine gute Dichtung zwischen dem jeweiligen Druckkontaktkörper und der Innenwandung des Isoliergehäuses, das vorzugsweise aus Keramik besteht, zu erhalten; denn bei Erwärmung entspannt sich der Schlauchabschnitt auf eine größere Wandstärke, vermutlich durch Aufreißen von vorher durch Elektronenstrahlung gebildeten Vernetzungen bzw. Querverbindungen oder Kristallisationskeimen. Vorteilhaft kann eine mechanische Bearbeitung der Innenwandung des Isoliergehäuses entfallen.

Die Erfindung wird nachfolgend anhand eines in der Zeichnung dargestellten Ausführungsbeispiels näher erläutert. Es zeigt

Fig. 1 ein Schnittbild eines steuerbaren Leistungs-Halbleiterbauelementes mit Gehäuse,

Fig. 2 einen Druckkontaktkörper mit aufgezogenem Schlauchabschnitt in vergrößerter Darstellung und

Fig. 3 den Einsatz zweier Druckkontaktkörper mit aufgezogenen Schlauchabschnitten in ein Isoliergehäuse.

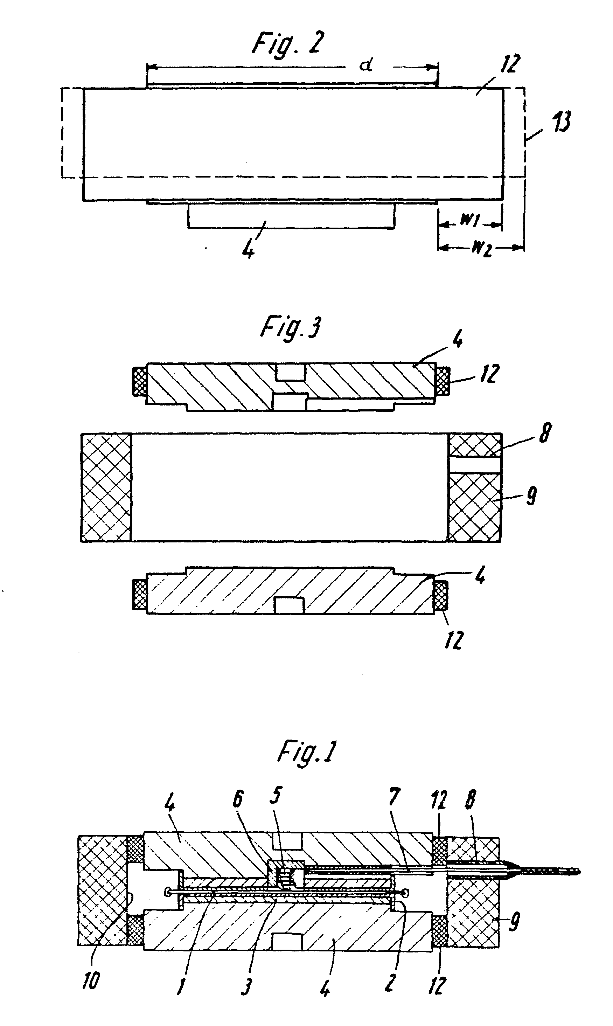

Figur 1 zeigt ein druckkontaktierbares, steuerbares Leistungs-Halbleiterbauelement mit Gehäuse in Dichtringtechnik. Vom scheibenförmigen Halbleiterkörper 1 aus schließen sich an jede seiner Hauptoberflächen an: ein Napf 2 aus duktilem Silber, dessen Ränder von der Hauptoberfläche des Halbleiterkörpers 1 abgekehrt sind, eine in diesen Napf 2 eingelegte Metallronde 3, vorzugsweise aus Molybdän, und ein Druckkontaktkörper vorzugsweise aus Kupfer. Die in der Zeichnung obere Hauptoberfläche des Halbleiterkörpers 1 wird im Bereich ihrer Steuerzone von einer Feder 5 direkt druckkontaktiert. Die Feder 5 ist durch einen Mantel 6 gegen den oberen Druckkontaktkörper 4 isoliert. Ein Steuerelektrodenanschluß 7 ist isoliert durch eine entsprechende Durchführung 8 eines die insoweit beschriebene Sandwich-Anordnung umfassenden Isoliergehäuse 9 hindurchgeführt.

Zwischen der Innenwand 10 des Isoliergehäuses 9 und den Randseiten der Druckkontaktkörper 4 befinden sich an den genannten Flächen dichtend anliegende Schlauchabschnitte 12 als Dichtringe.

Jeder dieser beiden Schlauchabschnitte 12 wird vor dem Einsatz in das Isoliergehäuse 9 auf seinen entsprechenden Druckkontaktkörper 4 gesetzt. Der durch Elektronenbestrahlung in axialer Richtung expandierte Schlauchabschnitt 12 besitzt eine relativ dünne Wandstärke w1, z. B. von 1 mm. Strichliniert ist in Fig. 2 unter 13 angedeutet, daß durch Erwärmung des Schlauchabschnittes 12 bei gleichbleibendem Durchmesser d eine größere Wandstärke w2, z. B. von 2 mm, erreichbar ist. Diese Erwärmung findet jedoch, wie bereits eingangs beschrieben, erst nach Einsatz in das Isoliergehäuse 9 statt.

Figur 3 zeigt den Einsatz der mit ihren Schlauchabschnitten 12 versehenen Druckkontaktkörper 4 aus Kupfer in das Isoliergehäuse 9. Bei Verwendung von Silbernäpfen 2 entspricht die Form der Druckkontaktkörper 4 derjenigen in Fig. 1. Wesentlich ist jedoch, daß die Druckkontaktkörper 4 randseitig keine Ausnehmung oder Nut zur Aufnahme der Schlauchabschnitte 12 besitzen müssen.

Nach Einsatz der Druckkontaktkörper 4 mit ihren Schlauchabschnitten 12 in das Isoliergehäuse 9 wird die Erwärmung vorgenommen. Man erkennt aus Fig. 1, daß die durch die Erwärmung bewirkte Entspannung der Schlauchabschnitte zu einer Ausfüllung des jeweiligen Dichtspaltes und einer dichten Flächenanlage an der Innenseite 10 des Isoliergehäuses 9 einerseits und an den Umfangsseiten der Druckkontaktkörper 4 andererseits führt. Durch Erwärmen wird der vorher durch Elektronenbestrahlung vernetzte Kunststoff in seinen inneren Querverbindungen aufgerissen, und es ergibt sich eine Materialvergrößerung. Vorzugsweise wird auf Temperaturen zwischen 393–433 K (120–160°C) erwärmt.

Es versteht sich, daß auch mehrere, vorzugsweise zwei, scheibenförmige Halbleiterkörper 1 in Stapeltechnik mit weiteren Metallronden in das Gehäuse eingesetzt werden können.

## Patentansprüche

1. Verfahren zur Herstellung eines dichten Gehäuses für einen scheibenförmigen, mindestens einen pn-Übergang aufweisenden Halbleiterkörper (1), welcher an jeder seiner beiden Hauptoberflächen über Elektrodenteile und einen Druckkontaktkörper (4) als Gehäuseabschluß thermisch und elektrisch druckkontaktierbar ist, wobei jeder Druckkontaktkörper (4) mit einem seinen Rand umlaufenden elastischen Dichtring versehen und in ein hohlzylindrisches, den Rand des Halbleiterkörpers (1) umschließendes — bei Verwendung für steuerbare Leistungs-Halbleiterbauelemente mit einer Durchführung für den Steuerelektrodenanschluß versehenes —, Isoliergehäuse (9) eingesetzt wird, dadurch gekennzeichnet, daß

a) durch Elektronenbestrahlung expandierte Schlauchabschnitte (1) als Dichtringe verwendet,
b) die Schlauchabschnitte (12) auf die beiden Druckkontaktkörper (4) aufgezogen und
c) nach ihrem Einsetzen in das Isoliergehäuse (9) zwecks Entspannung erwärmt werden, wobei sie unter Vergrößerung ihrer Wandstärke das Gehäuse abdichten.

2. Verfahren nach Anspruch 1, gekennzeichnet durch die Verwendung von Schlauchabschnitten (12) auf der Basis von synthetischem Kautschuk, vorzugsweise Viton.

## Claims

1. Process for manufacturing a filled casing for a disc-shape semi-conductor body (1) which has at least one pn-junction and which, on each of its two main surfaces can be pressure-bonded thermally and electrically via electrode parts and a pressure contact body (4) as a closure of the casing, each pressure contact body (4) being provided with a resilient sealing ring going around the rim there of and being inserted into a hollow cylindrical insulator casing (9) which encloses the rim of the semi-conductor body (1) and which, if used for controllable semi-conductor power components, is provided with a passage for the control electrode connection, characterised in that

a) sections of tubing (1) which have been expanded by electron irradiation are used as the sealing rings,
b) the sections of tubing (12) are drawn over the two pressure contact bodies (4) and
c) after they have been inserted into the insulator casing (9), they are heated for stress release, sealing the casing due to an increase in the wall thickness.

2. Process according to Claim 1, characterised by the use of sections of tubing (12) based on synthetic rubber, preferably Viton.

## Revendications

1. Procédé de fabrication d'un boîtier étanche pour un corps semi-conducteur (1) en forme de disque et présentant au moins une jonction pn qui, au niveau de chacune de ses deux faces principales, peut être contacté par pression, thermiquement et électriquement, par l'intermédiaire de parties d'électrodes et d'un corps de contact à pression (4) en tant que fermeture de boîtier, chaque corps de contact à pression (4) étant pourvu d'une bague d'étanchéité élastique qui encercle sa périphérie et étant inséré dans un boîtier isolant cylindrique creux (9), entourant la périphérie du corps semi-conducteur (1) et pourvu d'une traversée pour la connexion des électrodes de commande, dans le cas d'une application destinée à des composants semiconducteurs de puissance pouvant être commandés, caractérisé en ce que

a) on utilise comme bagues d'étanchéité des segments de tube flexible (12) expansé par bombardement électronique,

b) on tire les segments de tube flexible (12) sur les deux corps de contact à pression, et

c) on chauffe les segments de tube flexible, après leur introduction dans le boîtier isolant (9), en vue de les détendre, de sorte que l'augmentation de leur épaisseur de paroi assure l'étanchéité du boîtier.

2. Procédé suivant la revendication 1, caractérisé en ce qu'on utilise des segments de tube flexible (12) à base de caoutchouc synthétique, de préférence de Viton.

0 015 983

**Fig. 2**

**Fig. 3**

**Fig. 1**